**Europäisches Patentamt**

**European Patent Office**

**Office européen des brevets**

(19)

(11) Veröffentlichungsnummer: **0 054 119**
**A2**

(12) # EUROPÄISCHE PATENTANMELDUNG

(21) Anmeldenummer: **81108144.7**

(22) Anmeldetag: **09.10.81**

(51) Int. Cl.³: **H 05 K 3/00**

(30) Priorität: **15.12.80 DE 3047197**

(43) Veröffentlichungstag der Anmeldung:
**23.06.82 Patentblatt 82/25**

(84) Benannte Vertragsstaaten:
**BE CH FR GB IT LI NL**

(71) Anmelder: **SIEMENS AKTIENGESELLSCHAFT Berlin
und München
Postfach 22 02 61
D-8000 München 22(DE)**

(72) Erfinder: **Hecktor, Heint
Lochhauser Strasse 90
D-8031 Puchheim(DE)**

(54) **Verfahren zur Herstellung von Leiterplatten, die abschnittsweise relativ starre und demgegenüber relativ flexible Bereiche aufweisen.**

(57) Bei der Herstellung mehrlagiger Leiterplatten mit starren und flexiblen Bereichen werden entweder nur starre Lagen mit einer max. Dicke von 0,1 mm verwendet oder bei dickeren starren Lagen nach dem stromlosen Metallisieren die flexiblen Bereiche durch streifenförmigen Materialabtrag im Grenzbereich starr-flexibel und Schlitzung zwischen flexiblen Bereichen und abzutrennenden Teilen elektrisch isoliert, so daß entweder die Galvanikabdeckung (Ristonfolie) von der Stufe starr-flexibel nicht beschädigt wird oder infolge der Inselstruktur im flexiblen Bereich ein Reißen der Galvanikabdeckung ohne Folgen bleibt und außerdem gezielt Abflußöffnungen für die Badflüssigkeiten geschaffen werden.

FIG 2

EP 0 054 119 A2

SIEMENS AKTIENGESELLSCHAFT                Unser Zeichen

Berlin und München                       VPA 80 P 6 2 4 8 E

Verfahren zur Herstellung von Leiterplatten, die abschnittsweise relativ starre und demgegenüber relativ flexible Bereiche aufweisen

Die Erfindung bezieht sich auf ein Verfahren zur Herstellung von Leiterplatten, die abschnittsweise relativ starre und demgegenüber relativ flexible Bereiche aufweisen und bei dem die starren Bereiche durch Verpressen von starren Einzellagen mit flexiblen Einzellagen, die zumindest an ihren Leiterbahnen aufweisenden Außenseiten mit einer Abdeckfolie versehen sind, unter Verwendung von zumindest in den flexiblen Bereichen ausgesparten Verbundfolien erhalten werden, wobei die zunächst einstückigen starren Einzellagen nur entweder die eine oder beide Außenseiten der Leiterplatten bilden und die an ihren Außenseiten mit einer Metallkaschierung versehenen starren Einzellagen in den flexibel gewünschten Bereichen Aussparungen aufweisen und die Herstellung von metallisierten Bohrungen in den starren Bereichen nach dem Verspressen vorgesehen ist, wobei die Bohrungswände zunächst stromlos metallisiert werden.

Ein derartiges Verfahren ist aus der DE-AS 26 57 212 bekannt. Bei diesem bekannten Verfahren werden die starren Außenlagen auf der der flexiblen Lage zugewendeten Seite (Innenseite) entlang der Trennungslinie zwischen starrem und flexiblem Teil mit einer Nut versehen, wobei die Nuttiefe so gewählt wird, daß die Außenseiten der starren Lagen unverletzt bleiben, bevor die starren Lagen mit den flexiblen Lagen verpresst werden. Da außerdem in den später flexibel gewünschten Bereichen die zur Verbindung von starren Lagen und flexiblen Lagen verwendete Ver-

Rt 1 Sse - 12.12.80

bundfolie ausgespart bleibt, lassen sich, nach der Ausbildung von weiteren Nuten entlang der Trennungslinien
vom starren zum flexiblen Bereich von der Außenseite der
Leiterplatte her, die starren Lagen im flexibel gewünschten Bereich entfernen, der zunächst während weiterer
Fertigungsschritte von den starren Lagen abgedeckt war.

Bei diesem bekannten Verfahren müssen also nachträglich,
d.h. nach dem Verpressen der starren und flexiblen Lagen
relativ großflächige Teile der starren Lagen von der
Leiterplatte entfernt werden, wobei darauf geachtet werden muß, daß beim Verpressen der Lagen die Verbundfolie
nicht Randstellen der später herauszulösenden starren
Lagen mit den flexiblen Lagen verklebt. Es ist aus der
DE-AS 26 57 212 hierzu bekannt, durch das Einlegen von
Trennfolien zwischen starren und flexiblen Lagen in den
später flexibel gewünschten Bereichen eine solche Verklebung zu verhindern.

Aufgabe vorliegender Erfindung ist es demgegenüber, ein
Verfahren der eingangs genannten Art so auszubilden, daß
die Verwendung von Trennfolien in den später flexibel gewünschten Bereichen nicht erforderlich ist.

Erfindungsgemäß ergibt sich die Lösung dieser Aufgabe dadurch, daß die Aussparungen in den starren Lagen schon
vor dem Verpressen der starren und flexiblen Lagen miteinander vorgesehen werden und daß entweder nur starre
Einzellagen mit einer max. Dicke von ca. 0,1 mm ohne
Metallkaschierung gerechnet verwendet werden oder bei
Verwendung von demgegenüber dickeren starren Einzellagen
nach der stromlosen Metallisierung der Bohrungswände
jeder flexible Bereich von einem durch Materialabtrag
erhaltenen schmalen Streifen unterbrechungslos umgeben
wird.

0054119
80 P 6248 E

Die Erfindung geht dabei von der Erkenntnis aus, daß bei Verwendung von starren Einzellagen mit einer max. Dicke von ca. 0,1 mm die zwischen dem starren Bereich und dem flexiblen Bereich der Leiterplatte nach dem Verpressen noch vorhandene Stufe von einer während späterer Fertigungsschritte auf die Leiterplatte aufgebrachten, insbesondere aufgewalzten folienartigen Galvanikabdeckung ohne Beschädigung der Galvanikabdeckung (Fotolackschicht) überwunden werden kann. Während der Galvanisierung der Leiterplattenbohrungen kann daher keine unerwünschte Metallabschneidung in Bereichen stattfinden, die von der Galvanikabdeckung überzogen sind, insbesondere nicht in den flexiblen Bereichen der Leiterplatte, die z.B. bei der stromlosen Metallisierung der Bohrungswände ebenfalls mit einem dünnen Metallbelag versehen worden sind. Dieser dünne Metallbelag kann daher später, d.h. nach der galvanischen Verstärkung der Metallisierung der Bohrungswände und von auf der Außenseite der starren Bereiche vorgehenen Leiterbahnen, unschwierig abgeätzt werden. Bei dickeren starren Einzellagen reißt die Galvanikabdeckung allerdings im Bereich der Stufe zwischen den starren und den flexiblen Bereichen der Leiterplatte auf. Eine galvanische Metallschicht kann sich aber auch dann nicht in den flexiblen Bereichen bilden, da die flexiblen Bereiche durch den durch Materialabtrag erhaltenen schmalen Streifen elektrisch isoliert sind.

In weiterer Ausgestaltung des erfindungsgemäßen Verfahrens ist vorgesehen, daß jeder Streifen an der Grenze zwischen flexiblen und starren Bereichen durch Abflachen der freien Kante des starren Bereiches erhalten wird.

Auf diese Weise kann der Streifen zur elektrischen Isolierung der flexiblen Bereiche besonders einfach hergestellt werden.

Schließlich kann noch vorgesehen sein, daß an jeder Grenze zwischen flexiblen Bereichen und später abzutrennenden Teilen der Leiterplatte der Streifen durch einen die Leiterplatte vollständig durchdringenden Schlitz gebildet wird, und daß insbesondere dieser Schlitz in einen nur von den flexiblen Lagen gebildeten Abschnitt der Leiterplatte eingearbeitet wird.

Durch diese Schlitze wird erreicht, daß Badflüssigkeit, von Bädern, z.B. Galvanikbäder, Ätzbäder oder dergleichen, durch die die Leiterplatten im Zuge der Fertigung geführt werden und die durch Einrisse in der Galvanikabdeckung unter diese gelangt ist, insbesondere im Bereich der Abstufung zwischen dem starren und dem flexiblen Bereich der Leiterplatte, oder in dem tieferen flexiblen Bereich sich angesammelt hat, von einer Seite auf die andere Seite der Leiterplatte übertreten und von der Leiterplatte selbst abfließen kann.

Ausführungsbeispiele der Erfindung werden nachstehend anhand von zwei Figuren noch näher erläutert.

Dabei zeigen

Fig. 1    stark vergrößert, schematisch und ohne maßstäbliche Abmessungsverhältnisse, in Seitenansicht einen Ausschnitt aus einer einen starren und einen flexiblen Bereich aufweisenden Leiterplatte und

Fig. 2    eine Ansicht von oben auf eine Leiterplatte mit einem flexiblen Bereich, der auf beiden Seiten in einen starren Bereich übergeht und der noch mit abzutrennenden Teilen der Leiterplatte zusammenhängt.

Im einzelnen ist den Figuren zu entnehmen, daß die Leiterplatte auf einer mittleren flexiblen Einzellage 1 aufbaut, die auf ihren beiden Seiten in üblicher Weise hergestellte, in der Figur nicht dargestellte Leiterbahnen
aufweist. Auf beiden Seiten ist diese flexible Einzellage mit Deckfolien 2 versehen, so daß die Leiterbahnen
der flexiblen Einzellage 1 abgedeckt sind.

Mit der flexiblen Einzellage 1 sind auf beiden Seiten
starre Lagen 3 verpreßt, wobei Verbundfolien 4 zwischen
die starren Lagen 3 und die flexible Lage 1 in den Bereichen 6,8 eingefügt sind, in denen die Leiterplatte
starr sein soll.

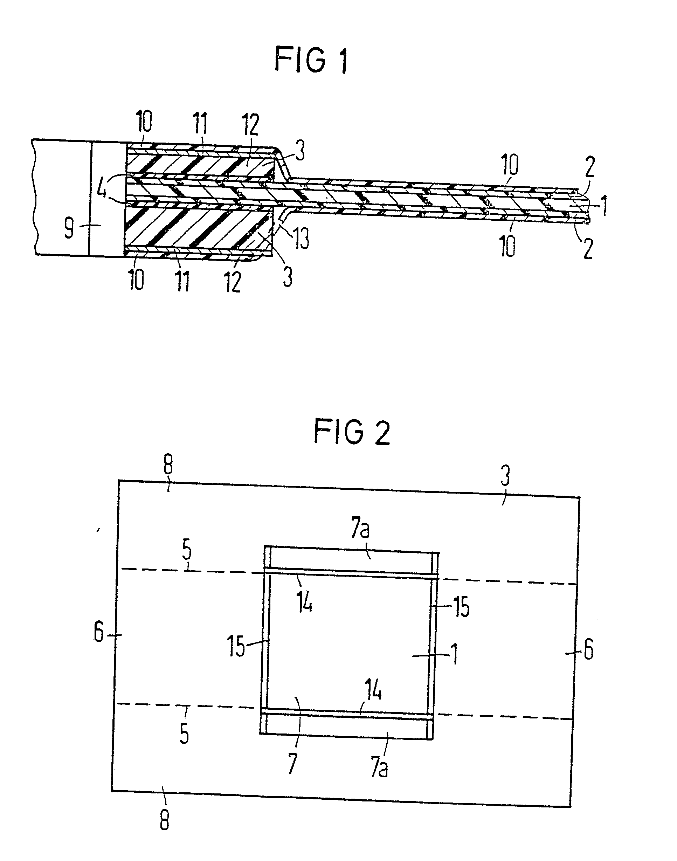

In dem flexibel gewünschten Bereich 7 der Leiterplatte,
ein solcher Bereich ist in Fig. 2 zwischen den beiden
strichlierten Linien 5 und zwischen den beiden starren
Bereichen 6 vorgesehen, sind die starren Lagen 3 und in
entsprechender Weise die Verbundfolien 4 mit einer Aussparung versehen.

Damit während weiterer Herstellungsschritte nach dem Verpressen der starren und flexiblen Lagen dennoch zunächst
ein insgesamt als relativ starre Platte handhabbares Gebilde vorhanden ist, sind auch außerhalb derjenigen Bereiche 6,7 in denen später die Leiterplatte starr bzw.
flexibel sein soll, einstückig mit den starren Lagen der
Leiterplatte zusammenhängende starre Bereiche 8 vorgesehen, so daß der flexible Bereich 7 fensterartig innerhalb eines geschlossenen starren Bereichs angeordnet ist.

Da derartige Leiterplatten, die sowohl starre, als auch
flexible Bereiche aufweisen, vor allem dazu verwendet
werden, um innerhalb der starren Bereiche die über die
flexiblen Bereiche verlaufenden Leiterbahnen zu kontaktieren - auf diese Weise können mehrdimensionale Schaltungen aufgebaut werden, wobei innerhalb der flexiblen Bereiche die Verbindungsleitungen verlaufen -, müssen in den starren Bereichen zur Kontaktierung der Leiterbahnen Durchgangsbohrungen 9 vorgesehen werden, deren Bohrungswände einen leitenden Belag aufweisen, über den wenigstens eine Leiterbahn der flexiblen Lage z.B. an ein die Bohrung 9 an der Oberfläche der starren Lage umgebendes Lötauge angeschlossen wird.

Um die Bohrungswände der Bohrungen 9 mit einem Metallbelag versehen zu können, werden die nach dem Verpressen der starren und flexiblen Lagen innerhalb der starren Bereiche hergestellten Bohrungen 9 zunächst u.a. mit einem stromlos erzeugten dünnen Metallbelag versehen, der sich dabei auch über die gesamte Oberfläche der Leiterplatte erstreckt.

Anschließend wird auf die Leiterplatte als Galvanikabdeckung eine Fotolackschicht z.B. in Form einer auf die Leiterplatte aufwalzbaren Folie 10 aufgebracht und nur dort im Zuge weiterer Fertigungsschritte wieder entfernt, wo nachfolgend der stromlos hergestellte Metallüberzug galvanisch verstärkt werden soll, also z.B. im Bereich der Bohrungswände der Bohrungen 9 und im Bereich von Lötaugen oder Leiterbahnen, die auf der Außenseite der starren Lagen 3 gebildet werden sollen.

Um zu verhindern, daß die relativ spröde Galvanikabdeckung an der Kante 12 der oberen starren Lage 3 der Leiterplatte nach Fig. 1 reißt, ist diese starre Lage ohne deren Metallkaschierung 11 mit einer max. Dicke von höchstens 0,1 mm versehen. Es hat sich gezeigt, daß in diesem Fall die Galvanikabdeckung 10 die Kante 12 zwischen einem starren Bereich 6 oder 8 und einem flexiblen Bereich 7 bzw. 7a ausgleichen kann, ohne beschädigt zu werden. D.h., die Galvanikabdeckung bleibt, auch wenn die den flexiblen Bereichen entsprechenden Aussparungen in den starren Lagen schon vor dem Verpressen vorgesehen werden, überall dort voll funktionsfähig erhalten, wo keine galvanische Verstärkung einer vor'dem Aufbringen der Abdeckung 10 vorhandenen Oberflächenmetallisierung erwünscht ist.

Ist die Dicke der starren Lage 3 jedoch größer als 0,1mm, ein solcher Fall ist in Fig. 1 bezüglich der unteren starren Lage 3 dargestellt, dann haftet die folienartige Galvanikabdeckung 10 in einem flexiblen Bereich 7 bzw. 7a nur ungenügend und neigt außerdem dazu, an der Grenze zwischen starrem Bereich 6,8 und flexiblem Bereich 7,7a zu reißen. Mithin kann der Elektrolyt beim anschließenden Galvanisieren durch die Rißbildungen 13 in der Galvanikabdeckung 10 im flexiblen Bereich 7 unter die Galvanikabdeckung 10 eindringen, so daß es dort zu einer unerwünschten Metallablagerung beim Galvanisieren kommen kann.

Dies wird nun dadurch verhindert, daß nach der stromlosen Metallisierung der Leiterplatte, insbesondere der Bohrungswände der Bohrungen 9, und vor dem Aufbringen der Galvanikabdeckung, z.B. durch Fräsen öder Ritzen entlang der Grenze zwischen starrem Bereich 6,8 und flexiblem Bereich 7,7a, ein streifenförmiger Materialabtrag vorgenommen wird, der die stromlos aufgebrachte Metallschicht unterbricht. Vorteilhaft kann dies z.B. durch eine Abflachung der freien Kante 12 des starren Bereiches 6 erfolgen. Dagegen wird entlang der Grenzlinie zwischen einem flexiblen Bereich 7 und einem später abzutrennenden starren Bereich 8 der Leiterplatte noch innerhalb des flexiblen Bereiches, wodurch später auch ein Streifen 7a des flexiblen Bereiches abgetrennt wird, zweckmäßig ein durchgehender Schlitz 14 vorgesehen. Die Schlitze 14 und die z.B. durch Abflachung
der freien Kanten 12 gebildeten Streifen 15 müssen unterbrechungsfrei derart ineinander übergehen, daß der
gesamte flexible Bereich 7, der auch von der stromlos
aufgebrachten Metallschicht bedeckt ist, von der übrigen
Metallschicht, über die beim Galvanisieren der erforderliche Strom fließt, vollkommen isoliert ist, also Inselstruktur hat. Auf diese Weise kann eine teilweise Perforierung  oder Zerreißung der Galvanikabdeckung 10 im
flexiblen Bereich 7,7a in Kauf genommen werden, ohne daß
dies bei der Herstellung der Leiterplatte zu Beeinträchtigungen führt.

Die Schlitze 14 haben noch den weiteren Vorteil, daß sie
das Abfließen von Badflüssigkeit erleichtern, insbesondere auch den Durchtritt von Badflüssigkeiten von einer
Seite der Leiterplatte auf die andere, so daß sich kaum
Badflüssigkeit innerhalb des flexiblen Bereiches 7,7a
oder unterhalb der Galvanikabdeckung 10 im flexiblen
Bereich 7,7a z.B. in durch die Galvanikabdeckung gebildeten Taschen halten kann, was unerwünscht ist, da
es zu einer sogenannten Badverschleppung führen kann,
d.h. zu einem Transport von Badflüssigkeit aus einem Bad
in ein im Zuge des Herstellungsprozesses folgendes Bad.

Nach der galvanischen Verstärkung der Metallisierung
dort, wo es erwünscht ist, wird die Galvanikabdeckung
wieder entfernt und die unverstärkte dünne stromlos aufgebrachte Metallschicht abgeätzt.  Schließlich werden
entlang der Trennlinien 5  die nur zum Zwecke der Versteifung der Leiterplatte während des Herstellungsprozesses dienenden starren Bereiche 8, über die auch
mehrere Leiterplatten während der Herstellung zusammenhängen können, abgetrennt, wobei die Schlitze 14 zweckmäßig in die Trennlinien 5 einbezogen werden, und dadurch die z.B. aus zwei starren Bereichen 6 und einem diese beiden starren Bereiche verbindenden flexiblen Bereich 7 bestehende Leiterplatte erhalten.

4 Patentansprüche
2 Figuren

Bezugszeichenliste

| | |
|---|---|
| 1 | flexible Lage |
| 2 | Abdeckfolie |
| 3 | starre Lage |
| 4 | Verbundfolie |
| 5 | Trennlinie |
| 6 | starrer Bereich |
| 7,7a | flexibler Bereich |
| 8 | starrer Bereich abtrennbar |
| 9 | Bohrung |
| 10 | Galvanikabdeckung |
| 11 | Metallkaschierung |
| 12 | freie Kante |
| 13 | Rißbildung |
| 14 | Schlitze |
| 15 | Abflachung |

Patentansprüche

1. Verfahren zur Herstellung von Leiterplatten, die abschnittsweise relativ starre und demgegenüber relativ flexible Bereiche aufweisen und bei dem die starren Bereiche durch Verpressen von starren Einzellagen mit flexiblen Einzellagen, die zumindest an ihren Leiterbahnen aufweisenden Außenseiten mit einer Abdeckfolie versehen sind, unter Verwendung von zumindest in den flexiblen Bereichen ausgesparten Verbundfolien erhalten werden, wobei die zunächst einstückigen starren Einzellagen nur entweder die eine oder beide Außenseiten der Leiterplatten bilden und die an ihren Außenseiten mit einer Metallkaschierung versehenen starren Einzellagen in den flexibel gewünschten Bereichen Aussparungen aufweisen und die Herstellung von metallisierten Bohrungen in den starren Bereichen nach dem Verpressen vorgesehen ist, wobei die Bohrungswände zunächst stromlos metallisiert werden, d a d u r c h   g e k e n n z e i c h - n e t , daß die Aussparungen in den starren Lagen (3) schon vor dem Verpressen der starren mit den flexiblen Lagen miteinander vorgesehen werden und daß entweder nur starre Einzellagen (3) mit einer max. Dicke von ca. 0,1 mm ohne Metallkaschierung (11) gerechnet verwendet werden oder daß bei Verwendung von demgegenüber dickeren starren Einzellagen jeder flexible Bereich (7) nach der stromlosen Metallisierung der Bohrungswände von einem durch Materialabtrag erhaltenen schmalen Streifen (14,15) unterbrechungslos umgeben wird.

2. Verfahren nach Anspruch 1, d a d u r c h   g e - k e n n z e i c h n e t , daß jeder Streifen (15) an der Grenze zwischen flexiblen und starren Bereichen (7,6) durch Abflachen der freien Kante des starren Bereiches erhalten wird.

0054119

3. Verfahren nach Anspruch 1 und 2, d a d u r c h  g e - k e n n z e i c h n e t , daß an jeder Grenze zwischen flexiblen Bereichen (7) und später abzutrennenden Teilen (8) der Leiterplatte der Streifen durch einen die Leiterplatte vollständig durchdringenden Schlitz (14) gebildet wird.

4. Verfahren nach Anspruch 3, d a d u r c h  g e - k e n n z e i c h n e t, daß der Schlitz (14) in einen nur von den flexiblen Lagen gebildeten Abschnitt (7,7a) der Leiterplatte eingearbeitet wird.

FIG 1

FIG 2